# FASCICULE DE BREVET EUROPEEN

(11) **EP 3 551 593 B1**
(45) Date de publication et mention de la délivrance du brevet: **27.01.2021**
(21) Numéro de dépôt: 17816980.1
(22) Date de dépôt: 04.12.2017
(51) Int. Cl.: C04B 35/80, C04B 35/52, C04B 35/565, C04B 35/583, C04B 35/83, C23C 16/458

(54) **OUTILLAGE DE CONFORMATION ET INSTALLATION POUR L'INFILTRATION CHIMIQUE EN PHASE GAZEUSE DE PREFORMES FIBREUSES.**
FORMAUSRÜSTUNG UND ANLAGE ZUR CHEMISCHEN INFILTRATION IN DER GASPHASE VON FASERVORFORMEN
SHAPING EQUIPMENT AND FACILITY FOR GAS-PHASE CHEMICAL INFILTRATION OF FIBROUS PREFORMS

(30) Priorité: 07.12.2016 FR 1662040
(43) Date de publication de la demande: 16.10.2019
(73) Titulaire: Safran Ceramics, 33185 Le Haillan (FR)
(72) Inventeur: THIBAUD, Simon, 77550 Moissy-Cramayel (FR); DELCAMP, Adrien, 77550 Moissy-Cramayel (FR); BERTRAND, Sébastien, 77550 Moissy-Cramayel (FR); GOUJARD, Stéphane, 77550 Moissy-Cramayel (FR)
(74) Mandataire: Cabinet Beau de Loménie
(86) Numéro de dépôt international: PCT/FR2017/053374
(87) Numéro de publication internationale: WO 2018/104640

(56) Documents cités:
- EP-A1- 0 846 787
- EP-A1- 1 815 975
- EP-A2- 1 028 926
- EP-A2- 1 452 624

## Description

### Arrière-plan de l'invention

La présente invention concerne la réalisation de pièces en matériau composite et, plus particulièrement, l'outillage de conformation utilisé lors de la consolidation et/ou densification par infiltration chimique en phase gazeuse d'une préforme fibreuse destinée à former le renfort de la pièce en matériau composite.

Un domaine d'application de l'invention est celui de la réalisation de pièces en matériau composite thermostructural, c'est-à-dire en matériau composite ayant à la fois des propriétés mécaniques qui le rendent apte à constituer des pièces structurelles et la capacité de conserver ces propriétés jusqu'à des températures élevées. Des exemples typiques de matériaux composites thermostructuraux sont les composites carbone/carbone (C/C) ayant une texture de renfort en fibres de carbone densifiée par une matrice de carbone pyrolytique et les composites à matrice céramique (CMC) ayant une texture de renfort en fibres réfractaires (carbone ou céramique) densifiée par une matrice céramique.

Un processus bien connu de consolidation ou de densification de préformes fibreuses pour réaliser des pièces en composite C/C ou en CMC est l'infiltration chimique en phase gazeuse (CVI). Les préformes fibreuses à consolider ou à densifier sont placées dans un outillage de conformation multiperforé lui-même placé dans un réacteur ou four où il est chauffé. Un gaz réactif contenant un ou plusieurs précurseurs gazeux du matériau constitutif de la matrice est introduit dans le réacteur. La température et la pression dans le réacteur sont réglées pour permettre au gaz réactif de diffuser au sein de la porosité des préformes via les perforations du conformateur et d'y former un dépôt du matériau constitutif de la matrice par décomposition d'un ou plusieurs constituants du gaz réactif ou réaction entre plusieurs constituants, ces constituants formant le précurseur de la matrice. Un matériau d'interphase peut être en outre déposé avec la matrice par ce procédé.

Cependant, cette technique de consolidation/densification entraîne dans certains cas l'apparition de gradients de dépôt de matrice dans le sens de l'épaisseur de la préforme fibreuse ainsi que de surépaisseurs locales ou « pustules » à la surface de la préforme. En effet, entre la surface et le cœur de la préforme, l'épaisseur ou la quantité de matrice déposée peut varier d'un facteur 5. Ces inconvénients sont principalement dus à une inadaptation entre les caractéristiques de la préforme fibreuse (épaisseur de la préforme, nature des fibres, armure de tissage, etc.) et les caractéristiques structurelles du conformateur (nombre de perforations, taille et forme des perforations, etc.).

EP 1 452 624 A2 divulgue un outillage de conformation pour l'infiltration chimique en phase vapeur d'une préforme fibreuse.

### Objet et résumé de l'invention

L'invention a, par conséquent, pour but de fournir une solution pour un outillage de conformation dont les caractéristiques structurelles peuvent être définies en fonction de la préforme fibreuse à consolider et/ou densifier.

Ce but est atteint avec un outillage de conformation pour l'infiltration chimique en phase vapeur d'une préforme fibreuse, l'outillage comprenant une enceinte structurale formée d'au moins un premier support comportant une première zone multiperforée entourée par un premier plan de contact et un deuxième support comportant une deuxième zone multiperforée entourée par un deuxième plan de contact, les premier et deuxième supports étant maintenus l'un contre l'autre au niveau des première et deuxième zones de contact, caractérisé en ce que le premier support comporte sur sa face interne une première zone décaissée incluant la première zone multiperforée, en ce que le deuxième support comporte sur sa face interne une deuxième zone décaissée incluant la deuxième zone multiperforée, et en ce que l'outillage de conformation comprend en outre au moins des premier et deuxième éléments fonctionnels de moule de conformation présents respectivement dans la première et deuxième zones décaissées des premier et deuxième supports, chaque élément fonctionnel de moule de conformation comportant une première face ayant une forme déterminée correspondant à une forme de pièce à réaliser et une deuxième face maintenue en vis-à-vis de la face interne d'un support, chaque élément fonctionnel de moule de conformation comportant une pluralité de perforations et présentant au moins un nombre de perforations ou une taille de perforations ou une géométrie de perforations différent du nombre, de la taille ou de la géométrie des perforations présentes sur le support en vis-à-vis.

Ainsi, l'outillage de conformation selon l'invention comprend des éléments fonctionnels de moule de conformation amovibles dont la taille, le nombre et/ou la géométrie des perforations peuvent être définis en fonction des caractéristiques de la préforme fibreuse à consolider ou densifier afin d'obtenir un dépôt de matrice et/ou d'interphase plus homogène dans la préforme considérée. Il est ainsi possible de fabriquer des pièces en matériau composite ayant des propriétés mécaniques améliorées.

L'outillage de conformation de l'invention présente une grande souplesse d'adaptation tout en limitant le coût de cette adaptation. En effet, en cas d'adaptation de l'outillage de conformation à une préforme fibreuse particulière, seuls les éléments fonctionnels de moule de conformation sont changés, la partie principale de l'outillage, à savoir les supports formant l'enceinte structurale, étant conservée.

Selon une première caractéristique de l'outillage de conformation de l'invention, une couche d'appauvrissement poreuse est interposée entre la face interne de chaque support de l'enceinte structurale et la deuxième face de l'élément fonctionnel de moule de conformation maintenue en vis-à-vis de la face interne du support.

En consommant dans une couche d'appauvrissement une fraction des gaz précurseurs de la phase gazeuse avant que celle-ci n'atteigne la préforme fibreuse, on diminue la quantité de matrice déposée en surface de la préforme fibreuse, ce qui permet d'éviter un bouchage rapide de la porosité en surface de la préforme et de préserver plus longtemps un réseau de porosité permettant à la phase gazeuse de circuler jusqu'au au cœur de la préforme. On obtient ainsi un dépôt de matrice plus homogène dans l'épaisseur de la préforme limitant les gradients de dépôt dans la préforme.

La couche d'appauvrissement poreuse peut être notamment choisie parmi une des textures suivantes : mat de carbone, tissu bidimensionnel de carbone, feutre de carbone.

Selon une deuxième caractéristique de l'outillage de conformation de l'invention, les supports et les éléments de moule de conformation sont en un matériau choisi parmi au moins un des matériaux suivants : graphite, matériau composite carbone/carbone (C/C) et matériau composite à matrice céramique (CMC).

L'invention concerne également un chargement destiné à être placé dans une installation de densification par infiltration chimique en phase vapeur, ledit chargement comprenant une préforme fibreuse maintenue dans un outillage de conformation selon l'invention.

Comme indiqué ci-avant, un tel chargement réalisé avec l'outillage de conformation de l'invention permet non seulement de consolider ou densifier une préforme avec un dépôt de matrice et/ou d'interphase plus homogène mais aussi d'éviter la formation de surépaisseurs locales ou « pustules » à la surface de la préforme.

Selon un aspect particulier du chargement de l'invention, la préforme fibreuse est une préforme de pièce de moteur aéronautique.

L'invention concerne également un ensemble comprenant d'une part une installation de densification par infiltration chimique en phase gazeuse d'une préforme fibreuse, comportant une chambre de réaction, une conduite d'admission de gaz réactif située à une première extrémité de la chambre et débouchant dans une zone de préchauffage, et une conduite d'évacuation située au voisinage d'une seconde extrémité, et d'autre part au moins un chargement selon l'invention situé dans la chambre de l'installation.

L'invention a encore pour objet un procédé de fabrication d'une pièce en matériau composite comprenant :
- le placement d'une préforme fibreuse dans un outillage de conformation selon l'invention,
- la consolidation de la préforme poreuse par infiltration chimique en phase gazeuse d'une matrice,
- la densification de la préforme consolidée.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels:
- la figure 1 est une vue schématique éclatée montrant le montage et le chargement d'un outillage de conformation avec une préforme fibreuse conformément à un mode de réalisation de l'invention ;

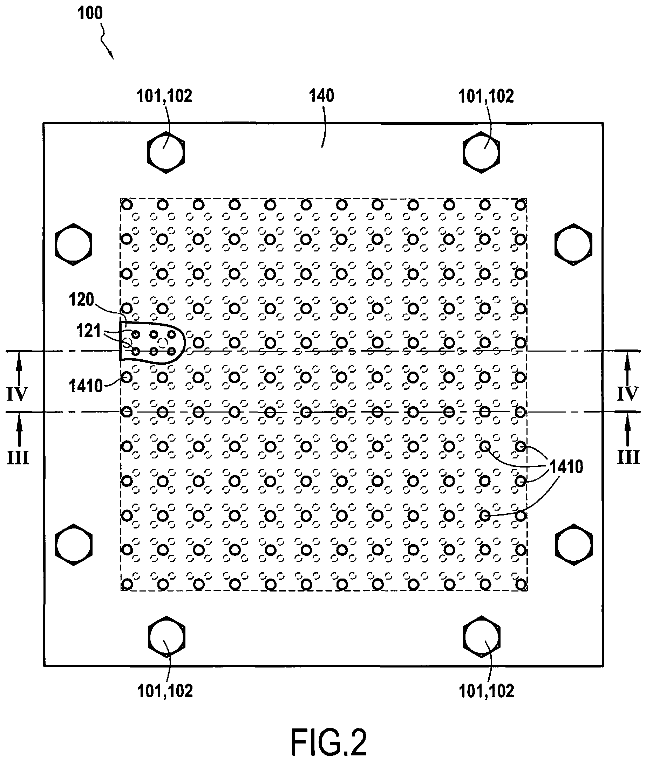

- la figure 2 est une vue de dessus de l'outillage de la figure 1 une fois monté ;
- la figure 3 est une vue en coupe selon le repère III de l'outillage de la figure 2 ;
- la figure 4 est une vue en coupe selon le repère IV de l'outillage de la figure 2 ;
- la figure 5 illustre une variante de réalisation d'un élément de moule de conformation ;
- la figure 6 est une vue schématique en perspective d'une installation de densification par infiltration chimique en phase gazeuse comprenant un chargement constitué par l'outillage et la préforme fibreuse de la figure 1.

### Description détaillée de mode de réalisation

La présente invention s'applique à la fabrication de pièces en matériau composite et en particulier en matériau composite thermostructural. Plus particulièrement, l'invention trouve une application avantageuse lors des étapes de consolidation et/ou de densification par infiltration chimique en phase gazeuse de préformes fibreuses.

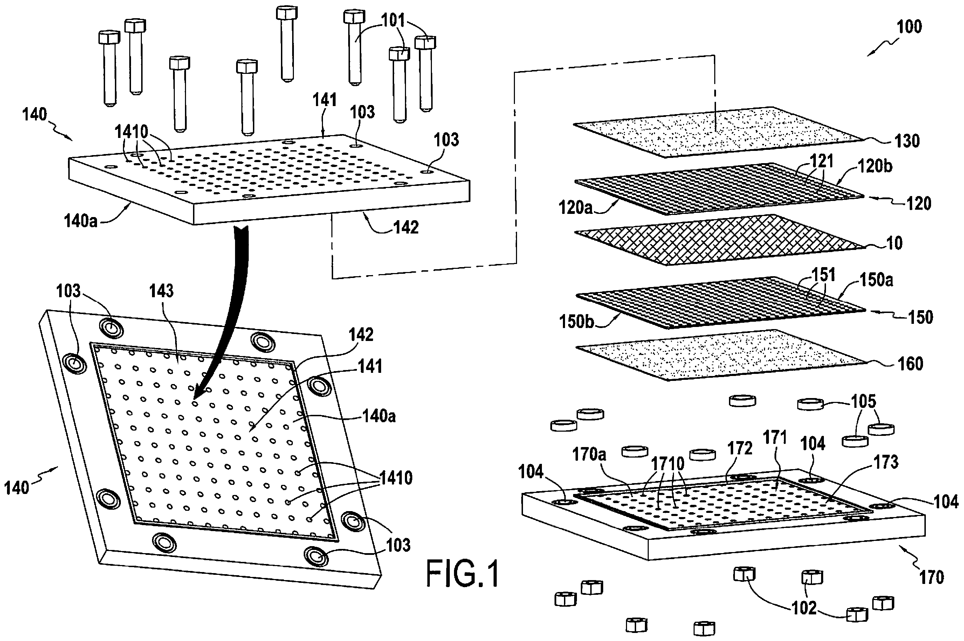

La figure 1 montre la réalisation d'un chargement comprenant la mise en place d'une préforme fibreuse 10 dans un outillage de conformation 100 conformément à un mode de réalisation de l'invention. Une fois réalisé, le chargement est destiné à être introduit dans une chambre de réaction d'une installation industrielle d'infiltration chimique en phase gazeuse. Dans l'exemple décrit ici, l'outillage 100 est destiné à recevoir des préformes fibreuse sous forme de plaques destinées notamment à la caractérisation des matériaux composites. L'outillage de conformation de l'invention peut être utilisé pour recevoir et conformer des préformes fibreuses en vue de la réalisation de pièces de formes variées comme par exemple des aubes ou des volets mobiles de tuyère de moteurs aéronautiques.

La préforme fibreuse 10 correspond à une texture fibreuse « sèche », c'est-à-dire non imprégnée d'une résine ou similaire. La texture fibreuse peut être en fibres de diverses natures, en particulier des fibres de céramique (par exemple carbure de silicium) ou de carbone. La texture fibreuse utilisée peut être de diverses natures et formes telles que notamment:
- tissu bidimensionnel (2D),
- tissu tridimensionnel (3D) obtenu par tissage 3D ou multicouches tel que notamment décrit dans le document WO 2010/061140 et dont le contenu est incorporé ici par référence,
- tresse,
- tricot,
- feutre,
- nappe unidirectionnelle (UD) de fils ou câbles ou nappes multidirectionnelle (nD) obtenue par superposition de plusieurs nappes UD dans des directions différentes et liaison des nappes UD entre elles par exemple par couture, par agent de liaison chimique ou par aiguilletage.

On peut aussi utiliser une structure fibreuse formée de plusieurs couches superposées de tissu, tresse, tricot, feutre, nappes, câbles ou autres, lesquelles couches sont liées entre elles par exemple par couture, par implantation de fils ou d'éléments rigides ou par aiguilletage.

L'outillage de conformation 100 comprend une enceinte structurale formée ici d'un premier support 140 et d'un deuxième support 170. Le premier support 140 comprend une première zone multiperforée 141 comportant une pluralité de perforations 1410 traversant le premier support dans son épaisseur, la zone multiperforée 141 étant entourée par un rebord 142.

Le deuxième support 170 comprend une deuxième zone multiperforée 171 comportant une pluralité de perforations 1710 traversant le deuxième support dans son épaisseur, la zone multiperforée 171 étant entourée par un rebord 172.

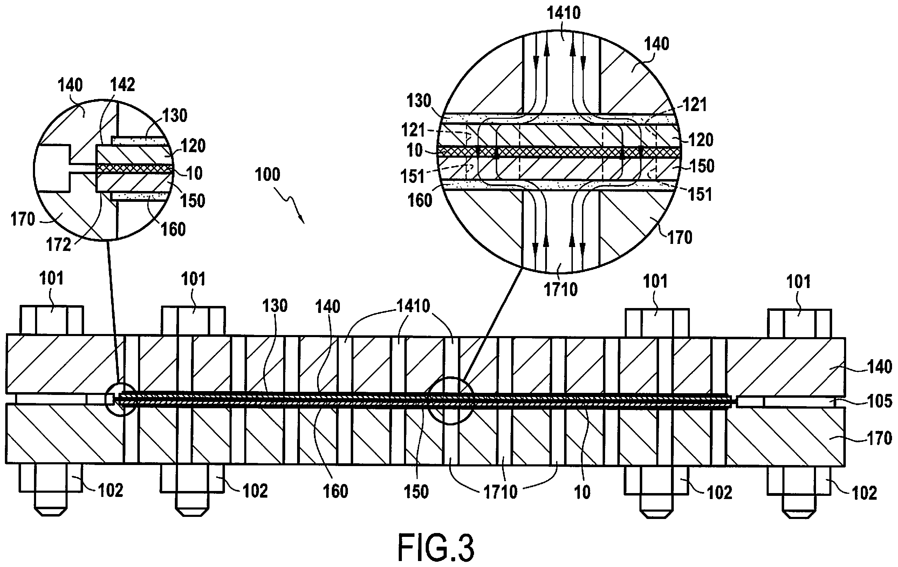

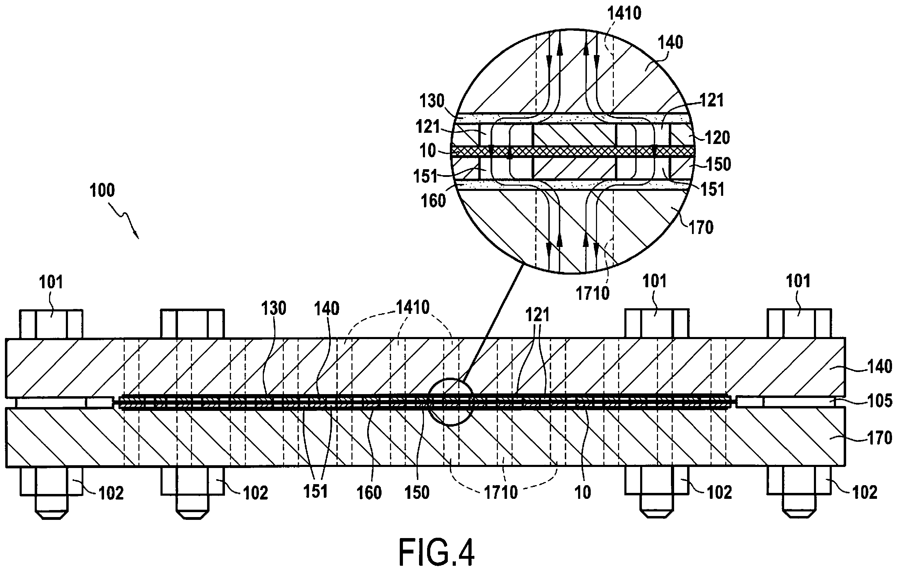

Conformément à l'invention, l'outillage de conformation 100 comprend également un premier élément fonctionnel de moule de conformation 120 et un deuxième élément fonctionnel de moule de conformation 150. Le premier élément fonctionnel de moule de conformation 120 est destiné être logé dans une première zone décaissée 143 présente sur la face interne 140a du premier support 140 et incluant la première zone multiperforée 141, le premier élément fonctionnel de moule de conformation 120 reposant sur le rebord 142 qui permet de maintenir cet élément à distance de la face interne 140a du premier support 140 (figures 3 et 4). Le deuxième élément fonctionnel de moule de conformation 150 est destiné à être logé dans une deuxième zone décaissée 173 présente sur la face interne 170a du deuxième support 170 et incluant la deuxième zone multiperforée 171, le deuxième élément fonctionnel de moule de conformation 150 reposant sur le rebord 172 qui permet de maintenir cet élément à distance de la face interne 170a du deuxième support 170 (figures 3 et 4). Les premier et deuxième éléments fonctionnels de moule de conformation 120 et 150 comporte chacun une première face 120a, respectivement 150a, ayant une forme déterminée correspondant à une forme de pièce à réaliser, ici une plaque. Le premier élément fonctionnel de moule de conformation 120 comporte une deuxième face 120b destinée à être maintenue en vis-à-vis de la face interne 140a du premier support 140 au niveau de la première zone décaissée 143 par le rebord 142 tandis que le deuxième élément fonctionnel de moule de conformation 150 comporte une deuxième face 150b destinée à être maintenue en vis-à-vis de la face interne 170a du deuxième support 170 au niveau de la deuxième zone décaissée 173 par le rebord 172. Les premier et deuxième éléments fonctionnels de moule de conformation 120 et 150 comportent une pluralité de perforations 121 et 151.

Conformément à l'invention, le nombre, la taille et/ou la géométrie des perforations 121 et 151 présentes respectivement sur les premier et deuxième éléments fonctionnels de moule de conformation 120 et 150 diffèrent par rapport au nombre, la taille et/ou la géométrie des perforations présentes sur le support en vis-à-vis. Dans l'exemple décrit ici, le premier élément fonctionnel de moule de conformation 120 comporte un nombre plus important de perforations 121 que le nombre de perforations 1410 présentes sur le premier support 140. De même, le deuxième élément fonctionnel de moule de conformation 150 comporte un nombre plus important de perforations 151 que le nombre de perforations 1710 présentes sur le deuxième support 170. Cela permet d'augmenter le nombre de points d'entrée de la phase gazeuse dans la texture fibreuse et de fractionner la phase gazeuse entrant par les perforations 1410 et 1710 des supports 140 et 170 avant son entrée en contact avec la préforme fibreuse. On limite ainsi les surépaisseurs locales et les gradients d'épaisseurs de dépôt dans l'épaisseur de la pièce à consolider ou la formation de pustules dans la préforme fibreuse.

En outre, les perforations 121 et 151 sont de préférence positionnées respectivement sur les premier et deuxième éléments fonctionnels de moule de conformation 120 et 150 de manière décalée par rapport au perforations 1410 et 1710 présentes respectivement sur les premier et deuxième supports 140 et 170 (figures 3 et 4). Cela permet de limiter encore l'apparition de surépaisseurs locales et de limiter les gradients d'épaisseurs de dépôt dans l'épaisseur de la pièce à consolider ou la formation de pustules dans la préforme fibreuse.

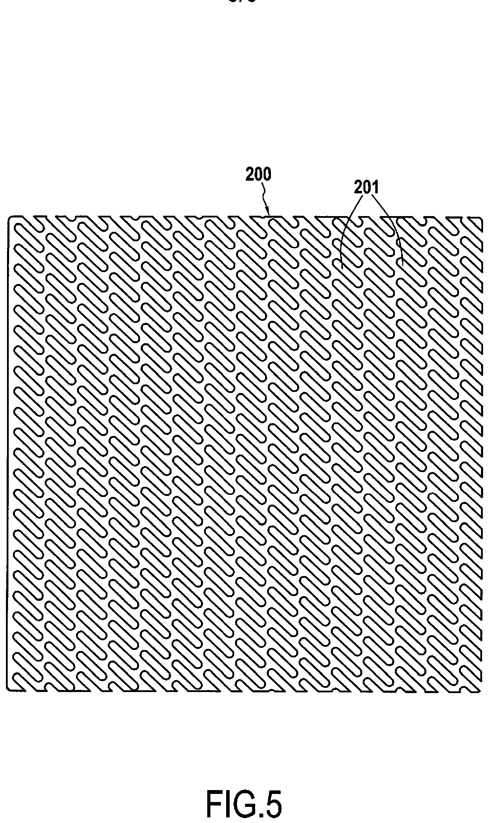

La figure 5 illustre une variante de réalisation d'un élément fonctionnel de moule de conformation 200 comportant une pluralité de perforations 201 de forme oblongue. D'autres formes de perforations peuvent être envisagées en fonction de paramètres liés à la préforme fibreuse à densifier. Dans le cas du moule de conformation 200, on augmente la surface globale des perforations à travers lesquelles la préforme fibreuse est exposée aux gaz précurseurs entrant dans l'outillage par les supports de l'enceinte structurale. On limite aussi dans ce cas l'apparition de surépaisseurs locales ou pustules dans la préforme fibreuse.

Selon un aspect particulier de l'invention, une couche d'appauvrissement poreuse peut être interposée entre un support de l'enceinte structurale et un élément fonctionnel de moule de conformation. Dans l'exemple décrit ici, une première couche poreuse d'appauvrissement 130 est interposée entre la face interne 140a du premier support 140 et la deuxième face 120b du premier élément fonctionnel de moule de conformation 120 maintenue à distance de la face interne 140a par le rebord 142 tandis qu'une deuxième couche d'appauvrissement 160 est interposée entre la face interne 170a du deuxième support 170 et la deuxième face 150b du deuxième élément fonctionnel de moule de conformation 150 maintenue à distance de la face interne 170a par le rebord 172. Les couches poreuses d'appauvrissement 130 et 160 permettent de « pré-consommer » une partie des gaz précurseurs de la phase gazeuse entrant par les performations 141 et 171 des supports 140 et 170. On limite ainsi les gradients de dépôts de matrice dans la préforme fibreuse. En effet, en consommant une fraction des gaz précurseurs de la phase gazeuse avant que celle-ci n'atteigne la préforme fibreuse, on diminue la quantité de matrice déposée en surface de la préforme fibreuse, ce qui permet d'éviter un bouchage rapide de la porosité en surface de la préforme et de préserver plus longtemps un réseau de porosité permettant à la phase gazeuse de circuler jusqu'au au cœur de la préforme. On obtient ainsi un dépôt de matrice plus homogène dans l'épaisseur de la préforme limitant les gradients de dépôt dans la préforme. Les couches poreuses d'appauvrissement peuvent être notamment réalisées à partir de tissus bidimensionnels en fibres de carbure de silicium (SiC) ou de feutres de fibres de carbone.

Les supports formant l'enceinte structurale ainsi que les éléments fonctionnels de moule de conformation peuvent être réalisés notamment en graphite ou en d'autres matériaux aptes à résister aux températures rencontrées lors des opérations de consolidation ou densification chimique en phase gazeuse tels que les matériaux composites carbone/carbone ou à matrice céramique (CMC) comme par exemple des matériaux C/SiC (renfort en fibres de carbone densifié par une matrice carbure de silicium) ou SiC/SiC (renfort et matrice en carbure de silicium).

Dans l'exemple décrit ici, la préforme fibreuse 10 est une préforme obtenue par tissage tridimensionnel de fibres SiC de type Hi-Nicalon® Type S.

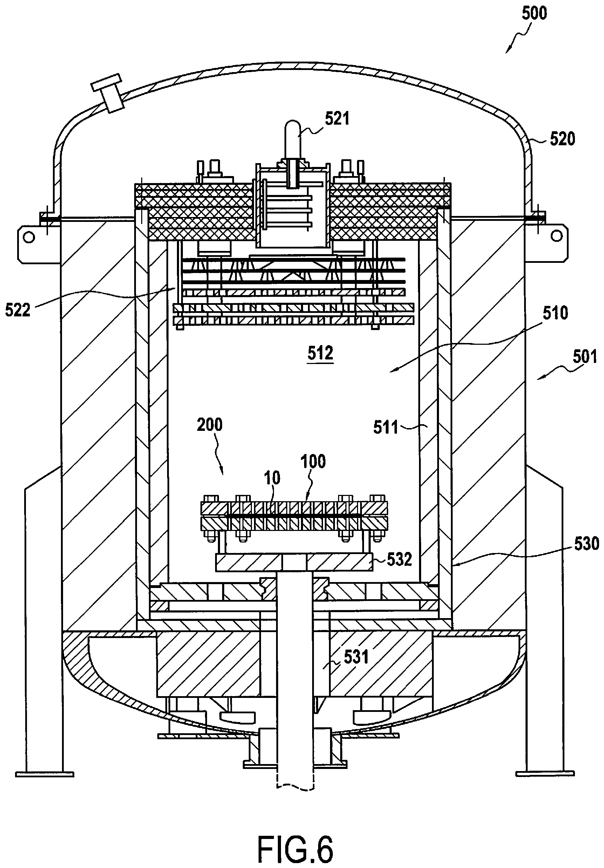

La préforme fibreuse 10 est placée dans l'outillage de conformation 100 (figures 3 et 4) en vue de sa consolidation par infiltration chimique en phase gazeuse. L'outillage est fermé par des organes de serrage constitués ici de vis 101 et d'écrou 102, des entretoises 105 étant utilisées pour régler l'ajustement entre les deux supports 140 et 170. La préforme fibreuse 10 et l'outillage 100 constitue un chargement 200 qui est placé dans une installation ou four d'infiltration chimique en phase gazeuse 500 illustrée sur la figure 6. De façon connue en soi, l'installation d'infiltration chimique en phase gazeuse 500 comprend une enceinte cylindrique 501 délimitant une chambre de réaction 510 fermée dans sa partie supérieure par un couvercle démontable 520 muni d'une conduite d'admission de gaz 521 qui débouche dans une zone de préchauffage 522 permettant de réchauffer le gaz avant sa diffusion dans la chambre de réaction 510 contenant la ou les préformes à densifier. Les gaz résiduels sont extraits au niveau du fond 530 de l'installation par une conduite d'évacuation 531 qui est reliée à des moyens d'aspiration (non représentés). Le fond 530 comporte un support 532 sur lequel le chargement 200 est destiné à être déposé.

Le chauffage dans la zone préchauffage ainsi qu'à l'intérieur de la chambre de réaction 510 est produit par un suscepteur en graphite 511 formant un induit couplé électromagnétiquement avec un inducteur (non représenté). L'espace présent dans la chambre de réaction 510 entre la zone de préchauffage 522 et le support 532 correspond au volume de chargement utile 512 de l'installation d'infiltration 500, c'est-à-dire le volume disponible pour charger des préformes fibreuses à densifier.

La préforme 10 est consolidée par infiltration chimique en phase gazeuse. Afin d'assurer la consolidation de la préforme, un gaz réactif contenant au moins un ou plusieurs précurseurs du matériau de la matrice à déposer est introduit dans la chambre de réaction 510. Dans le cas d'un matériau céramique, comme ici du carbure de silicium (SiC), on peut utiliser, comme bien connu en soi, du méthyltrichlorosilane (MTS) en tant que précurseur de SiC. Dans le cas du carbone par exemple, on utilise des composés gazeux hydrocarbonés, typiquement du propane, du méthane ou un mélange des deux. La consolidation de la préforme poreuse est assurée, de façon bien connue en soi, par dépôt au sein de celle-ci du matériau de la matrice produit par décomposition du ou des précurseurs contenus dans le gaz réactif diffusant à l'intérieur de la porosité interne accessible de la préforme. Les conditions de pression et de température nécessaires pour obtenir des dépôts de matrices diverses par infiltration chimique en phase gazeuse sont bien connues en elles-mêmes. Un gradient de pression est établi entre la conduite d'alimentation 521 et la conduite d'évacuation 531 afin de favoriser le passage des flux de gaz réactif dans la préforme.

Des essais de consolidation d'une préforme fibreuse avec un outillage de conformation conforme à l'invention et du même type que l'outillage 100 décrit précédemment a été réalisé. Plus précisément, pour ces essais les éléments suivants ont été utilisés :
- préforme obtenue par tissage tridimensionnel de fibres SiC Hi-Nicalon® Type S, la préforme présentant une forme de plaque,
- premier et deuxième supports de l'outillage de conformation présentant dans leur zone multiperforée des perforations ayant un diamètre de 10 mm (phi 10 mm), les perforations étant espacées les unes des autres suivant un pas de centre à centre de 20 mm,
- premier et deuxième éléments fonctionnels de moule de conformation comportant des perforations d'un diamètre de 5 mm (phi 5 mm) et espacées les unes des autres suivant un pas de centre à centre de 8 mm,
- couche poreuse d'appauvrissement interposée entre chaque support de l'outillage de conformation et chaque élément de moule de conformation, chaque couche étant réalisée à partir d'un feutre constitué d'un enchevêtrement de fibres de graphite commercialisé par la société Le Carbone Lorraine, sous la référence RVG 2000.

La préforme a été consolidée par infiltration chimique en phase gazeuse d'une phase de BN et de SIC.

Ces essais ont montré une diminution du gradient d'épaisseur de dépôt, dans l'épaisseur de la pièce, d'un facteur 5 en comparaison avec un outillage de conformation de l'art antérieur. De plus, les gradients d'épaisseur de dépôt, en surface de pièce, entre une zone directement exposée au gaz (zone de la préforme en vis-à-vis d'une perforation d'un élément fonctionnel de moule de conformation) et une zone masquée (zone de la préforme située entre deux perforations d'un élément fonctionnel de moule de conformation) ont été diminués d'un facteur 5 à 8 en comparaison avec un outillage de conformation de l'art antérieur.

## Revendications

1. Outillage de conformation (100) pour l'infiltration chimique en phase vapeur d'une préforme fibreuse, l'outillage comprenant une enceinte structurale formée d'au moins un premier support (140) comportant une première zone multiperforée (141) et un deuxième support (170) comportant une deuxième zone multiperforée (171), les premier et deuxième supports étant maintenus l'un contre l'autre,
**caractérisé en ce que** le premier support (140) comporte sur sa face interne (140a) une première zone décaissée (143) incluant la première zone, multiperforée (141), **en ce que** le deuxième support (170) comporte sur sa face interne (170a) une deuxième zone décaissée (173) incluant la deuxième zone multiperforée (172), et **en ce que** l'outillage de conformation (100) comprend en outre au moins des premier et deuxième éléments fonctionnels de moule de conformation (120, 150) présents respectivement dans la première et deuxième zones décaissées (143, 173) des premier et deuxième supports (140, 170), chaque élément fonctionnel de moule de conformation comportant une première face (120a ; 150a) ayant une forme déterminée correspondant à une forme de pièce à réaliser et une deuxième face (120b ; 150b) maintenue en vis-à-vis de la face interne d'un support, chaque élément fonctionnel de moule de conformation comportant une pluralité de perforations (121 ; 151) et présentant au moins un nombre de perforations, une taille de perforations ou une géométrie de perforations différent du nombre, de la taille ou de la géométrie des perforations présentes sur le support en vis-à-vis.

2. Outillage selon la revendication 1, dans lequel une couche d'appauvrissement poreuse (130 ; 160) est interposée entre la face interne de chaque support (140 ; 170) de l'enceinte structurale et la deuxième face de l'élément fonctionnel de moule de conformation (120 ; 150) maintenue en vis-à-vis de la face interne du support.

3. Outillage selon la revendication 2, dans lequel la couche d'appauvrissement poreuse est choisie parmi une des textures suivantes : mat de carbone, tissu bidimensionnel de carbone, feutre de carbone.

4. Outillage selon l'une quelconque des revendications 1 à 3, dans lequel que les supports (140, 170) et les éléments fonctionnels de moule de conformation (120, 150) sont en un matériau choisi parmi au moins un des matériaux suivants : graphite, matériau composite carbone/carbone (C/C) et matériau composite à matrice céramique (CMC).

5. Chargement (200) destiné à être placé dans une installation de densification par infiltration chimique en phase vapeur (500), ledit chargement comprenant une préforme fibreuse (10) maintenue dans un outillage de conformation (100) selon l'une quelconque des revendications 1 à 4.

6. Chargement selon la revendication 5, dans lequel la préforme fibreuse est une préforme de pièce de moteur aéronautique.

7. Ensemble comprenant une installation de densification par infiltration chimique en phase gazeuse (500) d'une préforme fibreuse, comportant une chambre de réaction (510), une conduite d'admission de gaz réactif (521) située à une première extrémité de la chambre et débouchant dans une zone de préchauffage (522), et une conduite d'évacuation (531) située au voisinage d'une seconde extrémité, l'ensemble comprenant en outre au moins un chargement (200) selon la revendication 5 ou 6 situé dans la chambre.

8. Procédé de fabrication d'une pièce en matériau composite comprenant :
- le placement d'une préforme fibreuse (10) dans un outillage de conformation (100) selon l'une quelconque des revendications 1 à 4,
- la consolidation de la préforme poreuse par infiltration chimique en phase gazeuse d'une matrice,
- la densification de la préforme consolidée.

## Patentansprüche

1. Formwerkzeug (100) für die chemische Gasphaseninfiltration eines faserigen Vorformlings, wobei das Werkzeug eine strukturelle Hülle umfasst, die aus mindestens einem ersten Träger (140), der eine erste mehrfach gelochte Zone (141) aufweist, und einem zweiten Träger (170), der eine zweite mehrfach gelochte Zone (171) aufweist, gebildet wird, wobei der erste und der zweite Träger gegeneinander gehalten werden,
**dadurch gekennzeichnet, dass** der erste Träger (140) auf seiner Innenseite (140a) eine erste ausgesparte Zone (143) aufweist, die die erste mehrfach gelochte Zone (141) umfasst, dass der zweite Träger (170) auf seiner Innenseite (170a) eine zweite ausgesparte Zone (173) aufweist, die die zweite mehrfach gelochte Zone (172) umfasst, und dass das Formwerkzeug (100) ferner mindestens erste und zweite funktionelle Elemente einer gestaltgebenden Form (120, 150) umfasst, die jeweils in der ersten und der zweiten ausgesparten Zone (143, 173) des ersten und des zweiten Trägers (140, 170) vorhanden sind, wobei jedes funktionelle Element der gestaltgebenden Form eine erste Fläche (120a; 150a) mit einer spezifische Form entsprechend der Form eines herzustellenden Teils und eine zweite Fläche (120b; 150b) aufweist, die gegenüber der Innenseite eines Trägers gehalten wird, wobei jedes funktionelle Element der gestaltgebenden Form eine Vielzahl von Löchern (121; 151) umfasst und mindestens eine Anzahl an Löchern, eine Größe der Löcher oder eine Geometrie der Löcher aufweist, die sich von der Anzahl an Löchern, der Größe oder Geometrie der Löcher unterscheidet, die auf dem gegenüber liegenden Träger vorhanden sind.

2. Werkzeug nach Anspruch 1, wobei eine poröse Verarmungsschicht (130; 160) zwischen der Innenseite jedes Trägers (140; 170) der strukturellen Hülle und der zweiten Seite des funktionellen Elements der gestaltgebenden Form (120; 150) angeordnet ist, die gegenüber der Innenseite des Trägers gehalten wird.

3. Werkzeug nach Anspruch 2, wobei die poröse Verarmungsschicht ausgewählt wird aus einer der folgenden Texturen: Kohlenstoffmatte, zweidimensionales Kohlenstoffgewebe, Kohlenstofffilz.

4. Werkzeug nach einem der Ansprüche 1 bis 3, wobei die Träger (140, 170) und die funktionellen Elemente der gestaltgebenden Form (120, 150) aus einem Material bestehen, das ausgewählt wird aus mindestens einem der folgenden Materialien: Graphit, Kohlenstoff/Kohlenstoff (C/C)-Verbundwerkstoff und Keramikmatrix-Verbundwerkstoff (CMC).

5. Ladung (200), die dafür bestimmt ist, in einer Anlage zur Verdichtung durch chemische Gasphaseninfiltration (500) angeordnet zu werden, wobei die Ladung einen faserigen Vorformling (10) umfasst, der in einem Formwerkzeug (100) nach einem der Ansprüche 1 bis 4 gehalten wird.

6. Ladung nach Anspruch 5, wobei der faserige Vorformling ein Vorformling eines Flugzeugmotorenteils ist.

7. Anordnung umfassend eine Anlage zur Verdichtung durch chemische Gasphaseninfiltration (500) eines faserigen Vorformlings, welche eine Reaktionskammer (510), eine Zuleitung von reaktivem Gas (521), die sich an einem ersten Ende der Kammer befindet und in eine Vorwärmzone (522) mündet, und eine Ableitung (531), die sich angrenzend an ein zweites Ende befindet, umfasst, wobei die Anordnung ferner mindestens eine Ladung (200) nach Anspruch 5 oder 6 umfasst, die sich in der Kammer befindet.

8. Verfahren zur Herstellung eines Teils aus Verbundwerkstoff, umfassend:
- Platzieren eines faserigen Vorformlings (10) in einem Formwerkzeug (100) nach einem der Ansprüche 1 bis 4,
- Verfestigen des porösen Vorformlings durch chemische Gasphaseninfiltration einer Matrix,
- Verdichten des verfestigten Vorformlings.

## Claims

1. Shaping tooling (100) for chemical vapor infiltration of a fiber preform, the tooling comprising a structural enclosure formed by at least a first support (140) having a first multiply-perforated zone (141) and a second support (170) having a second multiply-perforated zone (171), the first and second supports being held one against the other,
the tooling being **characterized in that** the first support (140) includes on its inside face (140a) a first uncased zone (143) including the first multiply-perforated zone (141), **in that** the second support (170) includes in its inside face (170a) a second uncased zone (173) including the second multiply-perforated zone (172), and **in that** the shaping tooling (100) further comprises at least first and second shaping mold functional elements (120, 150) present respectively in the first and second uncased zones (143, 173) of the first and second supports (140, 170), each shaping mold functional element having a first face (120a; 150a) of a determined shape corresponding to a shape of the part that is to be made, and a second face (120b; 150b) held facing the inside face of a support, each shaping mold functional element having a plurality of perforations (121; 151) and presenting at least a number of perforations, a size of perforations, or a shape of perforations that differs from the number, the size, or the shape of the perforations present in the facing support.

2. Tooling according to claim 1, wherein a porous depletion layer (130; 160) is interposed between the inside face of each support (140; 170) of the structural enclosure and the second face of the shaping mold functional element (120; 150) held facing the inside face of the support.

3. Tooling according to claim 2, wherein the porous depletion layer is selected from one of the following textures: a carbon mat, a two-dimensional carbon fabric, a carbon felt.

4. Tooling according to any one of claims 1 to 3, wherein the supports (140, 170) and the shaping mold functional elements (120, 150) are made of a material selected from at least one of the following materials: graphite, carbon/carbon (C/C) composite material, and ceramic matrix composite (CMC) material.

5. A charge (200) for placing in an installation (500) for densification by chemical vapor infiltration, said charge comprising a fiber preform (10) held in shaping tooling (100) according to any one of claims 1 to 4.

6. A charge according to claim 5, wherein the fiber preform is a preform for an aeroengine part.

7. An assembly comprising an installation (500) for densification of a fiber preform by chemical vapor infiltration, the assembly comprising a reaction chamber (510), a reagent gas feed pipe (521) situated at a first end of the chamber and leading into a preheating zone (522), and a discharge pipe (531) situated in the vicinity of a second end, the assembly also including at least one charge (200) according to claims 5 or claim 6 situated in the chamber.

8. A method of fabricating a composite material part, the method comprising:
- placing a fiber preform (10) in shaping tooling (100) according to any one of claims 1 to 4;
- consolidating the fiber preform with a matrix by chemical vapor infiltration; and
- densifying the consolidated preform.
